# FASCICULE DE BREVET EUROPEEN

(11) **EP 0 685 929 B1**
(45) Date de publication et mention de la délivrance du brevet: **16.12.1998**
(21) Numéro de dépôt: 95401264.7
(22) Date de dépôt: 31.05.1995
(51) Int. Cl.: H03B 5/18, H03D 11/04

(54) **Oscillateur et récepteur comprenant cet oscillateur**
Oszillator und diesen verwendenden Empfänger
Oscillator and receiver using the same

(30) Priorité: 03.06.1994 FR 9406795
(43) Date de publication de la demande: 06.12.1995
(73) Titulaire: Morey, Gilles Marcel, F-38330 Saint-Ismier (FR)
(72) Inventeur: Morey, Gilles Marcel, F-38330 Saint-Ismier (FR)
(74) Mandataire: Casalonga, Axel

(56) Documents cités:
- EP-A- 0 271 190
- EP-A- 0 544 180
- US-A- 3 484 697
- PATENT ABSTRACTS OF JAPAN vol. 015 no. 367 (E-1112) ,17 Septembre 1991 & JP-A-03 145808 (MASPRO DENKOH CORP) 21 Juin 1991,
- D.L. WOLLESEN 'UHF transmission-line oscillator-design using the Smith chart.' 1966 , APPLICATION NOTE AN-216; MOTOROLA SEMICONDUCTOR PRODUCTS INC. , PHOENIX (US) * page 1 - page 5 *

## Description

La présente invention telle qu'elle est définie par les revendications concerne le domaine de l'électricité et de l'électronique et se rapporte plus particulièrement au domaine des oscillateurs et des récepteurs d'ondes radioélectriques notamment à super-réaction.

Dans l'état de la technique, le document JP-A-03 145 808 décrit un oscillateur dans lequel le collecteur d'un transistor est relié à un résonnateur diélectrique par deux lignes micro-strip dont l'une sert au réglage de la fréquence de l'oscillateur, entre lesquelles est prévue une capacité de couplage, la réaction étant obtenue par une autre capacité et une troisième ligne micro-strip. Les éléments montés en série entre le collecteur du transistor et le résonnateur introduisent des pertes du fait de leur impédance, influent sur la fréquence de fonctionnement de l'oscillateur et servent en celà au calage de cette fréquence.

Classiquement, les oscillateurs, utilisés en particulier dans les récepteurs à super-réaction, comprennent des éléments réactifs tels que selfs ou capacités.

Il est rappelé par ailleurs que le principe d'un récepteur à super-réaction est très ancien. Ses vertus sont principalement une très grande simplicité de moyens, nonobstant une assez grande sensibilité, donc une économie. Ses défauts sont principalement une sélectivité médiocre et un rayonnement électromagnétique relativement important sur sa fréquence de réception.

Un but de la présente invention est de proposer un récepteur à super-réaction de consommation très réduite dont la sélectivité et la stabilité sont améliorées et dont le spectre du rayonnement électromagnétique sur sa fréquence de réception est réduit.

La présente invention a tout d'abord pour objet un scillateur comprenant un élément actif ou amplificateur et un élément réactif de stabilisation.

Selon l'invention, cet oscillateur comprend un transistor bipolaire dont la base est reliée à un pôle de l'alimentation via une résistance et à un point commun via une résistance et dont l'émetteur est relié à ce pôle via une résistance, un résonnateur diélectrique coaxial tubulaire à céramique dont l'âme est branchée entre le collecteur dudit transistor et ledit point commun et le blindage audit point commun, et une capacité branchée entre la base dudit transistor et ledit point commun, ledit point commun étant relié à l'autre pôle de l'alimentation.

La présente invention a également pour objet un récepteur à super-réaction, qui comprend l'oscillateur ci-dessus et qui comprend en outre une antenne de réception d'ondes électromagnétiques couplée audit transistor, un signal de blocage-déblocage étant amené à la base de ce transistor.

Selon l'invention, l'émetteur dudit transistor peut avantageusement être relié à son collecteur via une capacité et audit point commun via une capacité.

Dans le cadre de la présente invention, les observations et analyses du demandeur l'ont amené à faire les constatations suivantes.

Les critères de stabilitié en température et de faible consommation d'un oscillateur sont particulièrement cruciaux en particulier si l'on cherche à réaliser un récepteur à super-réaction lui-même stable en température et à faible consommation, comprenant un oscillateur successivement bloqué puis débloqué, dont le temps nécessaire pour atteindre un niveau d'oscillations donné est fonction de l'énergie électromagnétique extérieure reçue sur sa fréquence d'oscillation propre au moment de la transition blocage-oscillations.

Le principe du récepteur à super-réaction, qui par essence est un récepteur à échantillonnage, impose que la fréquence d'échantillonnage soit grande devant l'harmonique le plus élevé composant le signal à recevoir.

La fréquence d'échantillonnage est en conséquence limitée vers le bas, ce qui, compte tenu du fait que le temps de mise en oscillations de l'oscillateur est fonction du coefficient de surtension de l'élément réactif, impose un coefficient maximum de surtension pratiquement utilisable.

Dans ce contexte, le choix de l'élément réactif de l'invention réalise un excellent compromis entre un coefficient de surtension adapté, une grande stabilité en température et, dans le cadre d'un récepteur à super-réaction, une bande passante utile maximale adaptée.

De plus, le choix de l'élément réactif selon l'invention, et son couplage direct avec l'élément actif, permet de réaliser un oscillateur et donc un récepteur à super-réaction, à très faible consommation. En effet, les pertes dues à l'élément réactif sont inversement proportionnellles à son coefficient de surtension.

Par ailleurs, un autre paramètre critique est lié au fait que la stabilité en température dépend essentiellement des variations des capacités parasites de l'élément actif.

Le couplage selon l'invention de l'élément réactif dans le collecteur d'un transistor bipolaire permet de s'affranchir en grande partie des variations de la capacité parasite base-émetteur qui est la plus critique. Les capacités parasites collecteur-base et collecteur-émetteur ont par ailleurs une influence moins importante.

Le choix selon l'invention d'un transistor bipolaire présente également l'avantage d'obtenir un gain important à faible courant et un coût réduit.

L'oscillateur selon l'invention et le récepteur à super-réaction selon l'invention qui le comprend sont particulièrement adaptés pour notamment la réception d'ondes électromagnétiques dans la gamme des fréquences radio-électriques et plus particulièrement dans les gammes de fréquences VHF et UHF entre quelques mégahertz et plusieurs gigahertz.

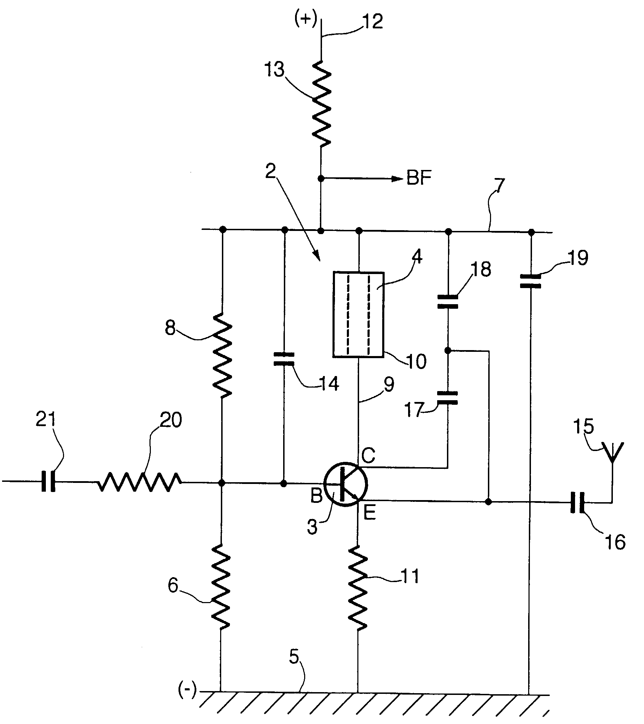

La présente invention sera mieux comprise à l'étude d'un oscillateur inclus dans un récepteur d'ondes électromagnétiques à super-réaction décrit à titre d'exemple non limitatif et illustré par la figure unique annexée.

Le récepteur à super-réaction représenté, qui est repéré d'une manière générale par la référence 1, comprend un oscillateur repéré d'une manière générale par la référence 2.

Cet oscillateur 2 comprend un élément actif composé par un transistor bipolaire 3 et un élément réactif composé par un résonnateur coaxial tubulaire à diélectrique céramique 4 directement couplé au collecteur du transistor 3.

La base du transistor 3 est reliée au pôle (-) d'une alimentation ou masse 5 via une résistance 6 et est reliée à un point commun 7 via une résistance 8.

L'âme 9 du résonnateur 4 est branchée entre le collecteur du transistor 3 et le point commun 7 et son blindage 10 est relié au point commun 7.

L'émetteur du transistor 3 est relié au pôle (-) 5 via une résistance 11.

Le point commun 7 est relié au pôle (+) 12 de l'alimentation via une résistance 13 et au pôle (-) via une capacité 19.

Afin de découpler la base du transistor 3, une capacité 14 est montée entre la base du transistor 3 et le point commun 7.

Une antenne 15 de réception d'ondes électromagnétiques est reliée à la base du transistor 3 via une capacité 16.

Une capacité de réaction 17 reboucle le collecteur à l'émetteur du transistor 3 tandis qu'une capacité 18 relie l'émetteur de ce transistor 3 au point commun 7. Cette capacité 17 de réaction forme avec la capacité 18 un adaptateur d'impédance collecteur-émetteur, la capacité 18 pouvant éventuellement être omise.

Le récepteur à super-réaction 1 est polarisé en un point proche du courant de démarrage des oscillations radio-fréquence, un signal de blocage-déblocage lui étant par exemple amené par la ligne 19 à travers une résistance 20 et une capacité 21.

La détection de la modulation basse fréquence de la porteuse radio-fréquence peut se faire par extraction de la variation du courant moyen consommé par l'étage oscillateur, par exemple au point commun 7, la fréquence d'échantillonnage étant filtrée par la capacité 19.

Pour améliorer la stabilité en température, on peut agir sur les paramètres de polarisation tels que tensions collecteur-base et collecteur-émetteur, ou insérer un ou plusieurs composants de coefficients de température opposés aux dérives constatées avant compensation, par exemple capacités à coefficients de température négatifs.

Grâce au montage décrit, on a pu constater un début d'oscillations de l'oscillateur 2 entre 20 et 50 UA à 400 mégahertz et une stabilité d'environ 100 kilohertz pour les températures comprises - 20°C et + 60°C, une consommation totale d'environ 40 UA à 400 mégahertz pour une bande passante radio-fréquences comprise entre 300 kilohertz et 400 kilohertz.

Un tel schéma peut subir de multiples variantes, en particulier en utilisant un transistor de type PNP permettant de relier le blindage du résonnateur diélectrique directement à la masse, ou en couplant totalement le résonnateur diélectrique en alternatif à l'élément actif à travers une capacité de découplage dont l'impédance à la fréquence d'oscillation soit faible devant l'impédance à cette même fréquence du résonnateur diélectrique.

Le récepteur 5 qui vient d'être décrit, à très faible consommation, simple, compact et économique, peut avantageusement être utilisé dans des applications domotiques de type télécommandes, de sécurité et de confort, ou pour des applications de type télécommande de verrouillage/déverrouillage de portes d'automobiles, de garages ou autres ou de portails.

## Revendications

1. Oscillateur comprenant un élément actif ou amplificateur et un élément réactif de stabilisation, caractérisé par le fait qu'il comprend un transistor bipolaire (3) dont la base est reliée à un pôle d'une alimentation via une résistance (6) et à un point commun (7) via une résistance (8) et dont l'émetteur est relié à ce pôle via une résistance (11), un résonnateur diélectrique coaxial tubulaire à céramique (4) dont l'âme (9) est branchée entre le collecteur dudit transistor et ledit point commun, le blindage (10) dudit résonnateur étant aussi connecté audit point commun, et une capacité (14) branchée entre la base dudit transistor et ledit point commun, ledit point commun (7) étant relié à l'autre pôle de l'alimentation.

2. Récepteur à super-réaction, caractérisé par le fait qu'il comprend l'oscillateur selon la revendication 1 et une antenne (15) de réception d'ondes électromagnétiques couplée audit transistor (3), un signal de blocage-déblocage étant amené à la base de ce transistor (3).

3. Récepteur à super-réaction selon la revendication 2, caractérisé par le fait que l'émetteur dudit transistor (3) est relié à son collecteur via une capacité (17) et audit point commun via une capacité (18).

## Patentansprüche

1. Oszillator mit einem aktiven oder verstärkenden Element, sowie mit einem reaktiven Stabilisatorelement, dadurch gekennzeichnet, dass er aufweist:
einen bipolaren Transistor (3), dessen Basis über einen Widerstand (6) an einen Pol einer Stromversorgungsquelle sowie über einen Widerstand (8) an einen gemeinsamen Schaltungspunkt (7) angeschlossen ist und dessen Emitter über einen Widerstand (11) an diesem Pol liegt,
einen koaxialen, keramischen, dielektrischen Zylinderresonator (4), dessen Innenleiter (9) zwischen dem Kollektor des Transistors und dem gemeinsamen Schaltungspunkt liegt, während die Abschirmung (10) des Resonators ebenfalls an den gemeinsamen Schaltungspunkt angeschlossen ist und
eine Kapazität (14), die zwischen der Basis des Transistors und dem gemeinsamen Schaltungspunkt liegt, wobei der gemeinsame Schaltungspunkt (7) zum anderen Pol der Stromversorgungsquelle hin verbunden ist.

2. Empfänger mit Pendelrückkopplung, dadurch gekennzeichnet, dass er den Oszillator nach Anspruch 1 und eine Antenne (15) für den Empfang elektromagnetischer Wellen aufweist, die an den Transistor (3) angekoppelt ist, wobei ein Sperr-/Freigabesignal der Basis des Transistors (3) zugeführt wird.

3. Empfänger mit Pendelrückkopplung nach Anspruch 2, dadurch gekennzeichnet, dass der Emitter des Transistors (3) über eine Kapazität (17) mit seinem Kollektor und über eine Kapazität (18) mit dem gemeinsamen Schaltungspunkt verbunden ist.

## Claims

1. Oscillator including an active component or amplifier and a stabilising reactive component, characterised in that it includes a bipolar transistor (3) the base of which is connected to one pole of a power supply via a resistor (6) and to a common point (7) via a resistor (8) and the emitter of which is connected to said pole via a resistor (11), a ceramic tubular coaxial dielectric resonator (4) the core (9) of which is connected between the collector of said transistor and said common point, the screen (10) of said resonator being also connected to said common point, and a capacitor (14) connected between the base of said transistor and said common point, said common point (7) being connected to the other pole of the power supply.

2. Superheterodyne receiver characterised in that it comprises the oscillator according to claim 1 and an antenna (15) for receiving electromagnetic waves connected to said transistor (3), a disabling/enabling signal being applied to the base of said transistor (3).

3. Superheterodyne receiver according to claim 2 characterised in that the emitter of said transistor (3) is connected to its collector via a capacitor (17) and to said common point via a capacitor (18).
